# EUROPEAN PATENT APPLICATION

(11) **EP 3 799 110 A1**
(43) Date of publication of application: **31.03.2021**
(21) Application number: 19807833.9
(22) Date of filing: 05.03.2019
(51) Int. Cl.: H01L 21/31, C23C 14/06, C23C 16/04, C23C 16/34, C23C 16/44, C30B 25/02, C30B 29/38

(54) **GROUP III NITRIDE SEMICONDUCTOR SUBSTRATE AND METHOD OF PRODUCING SAME**

(30) Priority: 23.05.2018 JP 2018098761
(71) Applicant: Sumco Corporation, Minato-ku, Tokyo 105-8634 (JP)
(72) Inventor: MATSUMOTO, Koji, Tokyo 105-8634 (JP); ONO, Toshiaki, Tokyo 105-8634 (JP); AMANO, Hiroshi, Nagoya-shi Aichi 464-8601 (JP); HONDA, Yoshio, Nagoya-shi Aichi 464-8601 (JP)
(74) Representative: Gerauer, Marc Philippé
(86) International application number: PCT/JP2019/008670
(87) International publication number: WO 2019/225112

(57) **Abstract**

[Problem]

To allow growth of a group III nitride semiconductor layer on a Si substrate with an AlN buffer layer interposed between same, so as to suppress group III material from diffusing into the Si substrate.

[Means for Solving the Problem]

The group III nitride semiconductor substrate manufacturing method includes: a step (S12) of forming an AlN coating on the inside of a furnace; steps (S13, S14A, S14B) of installing an Si substrate in the furnace covered with the AlN coating and forming an AlN buffer layer on the Si substrate; and a step (S15) of forming a group III nitride semiconductor layer on the AlN buffer layer.

## Description

### TECHNICAL FIELD

The present invention relates to a group III nitride semiconductor substrate and manufacturing method thereof and, more particularly, to a manufacturing method for a group III nitride semiconductor substrate in which a group III nitride semiconductor layer is formed on an Si substrate through an AlN buffer layer.

### BACKGROUND ART

A group III nitride semiconductor typified by GaN is larger in bandgap, higher in dielectric breakdown field strength, and higher in saturated electron mobility than other semiconductors, so that it is suitably used as a material for optical devices such as an LED (Light Emitting Diode) and an LD (Laser Diode) or power semiconductor devices.

With the current manufacturing technology, it is difficult to manufacture a bulk single crystal of a group III nitride semiconductor at low cost, so that there has been generally adopted a method of hetero-epitaxially growing a group III nitride semiconductor on a single crystal substrate such as a sapphire substrate, a silicon carbide (SiC) substrate, or a silicon (Si) substrate. Recently, attempts have been made to mass-produce a group III nitride semiconductor using an Si substrate on which a large-diameter, high-quality bulk single crystal can be produced at low cost.

When a group III nitride semiconductor is epitaxially grown on a substrate of a different type therefrom, many dislocations are typically generated in a group III nitride semiconductor layer due to lattice mismatch between a substrate material and a group III nitride semiconductor material. For example, the dislocation density on the surface of a GaN layer formed on a sapphire substrate is about 5 × 10⁸/cm², and dislocation density on the surface of the GaN layer formed on an Si substrate is about 1 × 10⁹/cm² to 1 × 10¹⁰/cm². Such a dislocation in the group III nitride semiconductor layer may cause a deterioration in light emission efficiency in an LED and may cause a current leak in a power semiconductor device.

In order to reduce the dislocation density of the group III nitride semiconductor layer, the group III nitride semiconductor layer is formed on a substrate through a buffer layer. For example, Patent Literature 1 states that an AlN buffer layer is grown at 950°C after thermal cleaning and nitriding treatment and is then further grown at 1230°C, followed by growth of a group III nitride semiconductor layer.

Patent Literature 2 relates to a technique for suppressing generation of pit-like defects on the surface of an AlN layer and discloses a method of manufacturing a semiconductor device including: a process of thermally cleaning the surface of a silicon substrate in an atmosphere containing hydrogen; a process of growing a first AlN layer on the silicon substrate using a first V/III material ratio by first feeding an Al raw material and then further feeding an N raw material; a process of growing a second AlN layer on the first AlN layer using a second V/III material ratio higher than the first V/III material ratio; and a process of growing a GaN based semiconductor layer on the second AlN layer.

Patent Literature 3 relates to a techique for reducing the occurrence of strain or defects in a substrate and an epitaxial growth layer even when epitaxial growth is performed using a hetero-substrate different in lattice constant and thermal expansion coefficient and for obtaining an epitaxial growth layer unlikely to have cracks even when a thick film is grown and discloses the formation of a group III-V compound semiconductor growth layer. In this method, a substrate that restricts a growth area by a mask made of SiO₂, etc., is used to form a facet structure of a group III-V compound semiconductor film by epitaxial growth. The facet structure is grown to cover the mask. Then, the facet structure is completely embedded to finally obtain a group III-V compound semiconductor growth layer having a flat surface.

### [Related Art]

### [Patent Literature]

[Patent Literature 1] Japanese Patent Application Laid-open No. 2005-072409
[Patent Literature 2] Japanese Patent Application Laid-open No. 2012-15305
[Patent Literature 3] Japanese Patent Application Laid-open No. H10-312917

### SUMMARY OF THE INVENTION

### [Problem to be Solved by the Invention]

In order to improve the crystallinity of the AlN buffer layer, it is preferable to grow AlN at a high temperature of 900°C or higher; however, when AlN is grown at such a high temperature, a deposit remaining on the inner surface of a crystal growth furnace such as an MOCVD furnace or in-furnace components therein is decomposed to cause a group III element such as Ga or In to scatter to adhere to the surface of an Si substrate. Further, an Al raw material or the group III element adhering to the surface of the Si substrate may diffuse into the Si substrate to act as a p-type dopant, thus disadvantageously reducing the resistivity of the surface of the Si substrate. The reduction in the resistivity of the surface of the Si substrate may also increase the number of current leak paths and the parasitic capacitance of a device formed on the Si substrate.

In the method described in Patent Literature 1, since AlN is grown first at a temperature of 900°C or higher, a group III element diffuses into the Si substrate to reduce the resistivity of the surface of the Si substrate. Further, in the method of Patent Literature 1, substrate nitriding treatment is performed with an NH₃ gas fed at a high temperature before the formation of AlN buffer layer on the assumption that a sapphire substrate or an SiC substrate is used; however, when the same nitriding treatment is applied to the Si substrate, amorphous silicon nitride is formed on the entire surface of the Si substrate, preventing AlN having good crystallinity from growing.

In the method described in Patent Literature 2, only the Al raw material is first fed when the growth of the first AlN layer is initiated, and then the N raw material is fed while feeding of the Al raw material is continued. Thus, excessive Al is more apt to diffuse into an Si substrate.

In the manufacturing method described in Patent Literature 3, the occurrence of cracks which may be caused by a difference in thermal expansion coefficient and lattice constant can be reduced to suppress introduction of defects. However, since the group III-V compound semiconductor film is formed on an Si substrate before the formation of the mask, a group III element such as Ga or In remaining in a furnace may scatter during a formation process of the group III-V compound semiconductor film to diffuse into the Si substrate. This reduces the resistivity of the surface of the Si substrate.

The present invention has been made in view of the above situation, and an object thereof is to provide a group III nitride semiconductor substrate manufacturing method capable of suppressing diffusion of a group III element into an Si substrate upon growth of a group III nitride semiconductor layer on the Si substrate. Another object of the present invention is to provide a group III nitride semiconductor substrate in which a group III nitride semiconductor layer is formed on an Si substrate with a high surface resistivity.

### [Means for Solving the Problems]

To solve the above problems, a group III nitride semiconductor substrate manufacturing method according to a first aspect of the present invention includes steps of: forming an AlN coating inside a furnace; installing an Si substrate in the furnace whose inside is covered with the AlN coating and forming an AlN buffer layer on the Si substrate; and forming a group III nitride semiconductor layer on the AlN buffer layer.

According to the present invention, it is possible to suppress Ga or In remaining in the furnace from scattering and adhering to the Si substrate during the formation of the AlN buffer layer and thus to suppress Ga or In from diffusing into the Si substrate. As a result, it is possible to suppress a reduction in the resistivity of the surface of the Si substrate due to diffusion of Ga or In.

In the present invention, the formation temperature of the AlN coating is preferably 1000°C to 1400°C, and the formation time of the AlN coating is preferably 1 min to 30 min. Thus, it is possible to uniformly form the AlN coating without involving a reduction in productivity.

In the present invention, it is preferable to alternately repeatedly introduce an Al raw material and an N raw material into the furnace in the step of forming the AlN coating. In this case, a per unit time for intruction of each of the Al raw material and the N raw material is preferably 0.5 sec to 10 sec. Further, the number of repetitions is preferably 5 to 200. Thus, the AlN coating can be uniformly formed inside the furnace.

The group III nitride semiconductor substrate manufacturing method according to the present invention preferably further includes, before the formation of the AlN coating, a step of cleaning the inside of the furnace under a hydrogen-containing atmosphere. By coating the inside of the furnace with AlN after a group III-V deposit remaining in the furnace is removed as much as possible, it is possible to enhance the effect of suppressing the Si substrate from being contaminated by Ga or In.

The group III nitride semiconductor substrate manufacturing method according to the present invention preferably further includes, before the formation of the AlN coating, steps of installing a dummy Si substrate in the furnace and taking the dummy Si substrate out of the furnace before installing the Si substrate in the furnace. This can prevent the AlN coating from being formed on the installation area for the Si substrate in the furnace.

In the present invention, the group III nitride semiconductor layer preferably contains a GaN layer. Thus, it is possible to manufacture a semiconductor substrate in which the GaN layer is formed on the Si substrate through the AlN buffer layer.

In the present invention, the growth temperature of the AlN buffer layer is preferably 400°C to 1200°C and, more preferably, 400°C to 800°C. Thus, it is possible to suppress diffusion of a group III element into the Si substrate during the step of forming the AlN buffer layer.

In the present invention, the step of forming the AlN buffer layer preferably includes steps of growing a first AlN layer at a growth temperature of 400°C to 800°C and growing a second AlN layer on the first AlN layer at a growth temperature of 900°C to 1200°C. Thus, it is possible to suppress diffusion of a group III element into the Si substrate during the step of forming of the AlN buffer layer and to improve the quality of the AlN buffer layer.

In the present invention, the step of forming the AlN buffer layer preferably includes, when an Al raw material and an N raw material are introduced into the furnace, introducing the Al raw material prior to the N raw material. This can suppress the Si substrate from being nitrided to thereby suppress deterioration in the crystallinity of AlN.

In at least one of the step of raising the in-furnace temperature before the start of formation of the AlN buffer layer, the step of forming the AlN buffer layer, and the step of forming the group III nitride semiconductor layer, an Ar gas is preferably used as an atmospheric gas in the furnace. The use of the Ar carrier gas makes it less likely to decompose the group III deposit in the furnace during growth than an H₂ carrier gas and does not nitride the surface of the Si substrate 10 unlike an N₂ gas. Thus, the crystallinity of the formed group III nitride semiconductor layer 30 is improved, and diffusion of the group III element into the Si substrate 10 can be suppressed.

Further, a group III nitride semiconductor substrate manufacturing method according to a second aspect of the present invention includes steps of: forming an AlN buffer layer on an Si substrate; and forming a group III nitride semiconductor layer on the AlN buffer layer. The step of forming the AlN buffer layer includes: feeding an Al raw material without feeding an N material into a furnace in which the Si substrate is installed, starting the feeding of the N raw material with the feeding of the Al raw material temporarily stopped, and resuming the feeding of the Al raw material to feed both the N raw material and the Al raw material.

According to the present invention, by introducing the N raw material after a predetermined time elapses from the start of feeding of the Al raw material into the furnace, it is possible to suppress the surface of the Si substrate from being nitrided. Further, the feeding of the Al raw material is temporarily stopped when the N raw material starts being fed, making it possible to prevent Al from being excessively fed. Thus, it is possible to suppress a reduction in the resistivity of the surface of the Si substrate due to diffusion of Al into the Si substrate.

In the present invention, the feeding time of the N raw material during temporary stop of feeding of the Al raw material is preferably 1 sec to 180 sec and, more preferably, 3 sec to 60 sec. Thus, it is possible to suppress excessive feeding of the Al raw material without involving a reduction in productivity.

In the present invention, the growth temperature of the AlN buffer layer is preferably 400°C to 1200°C and, more preferably, 400°C to 800°C. Thus, in the step of forming the AlN buffer layer, diffusion of a group III element into the Si substrate can be suppressed.

Further, a group III nitride semiconductor substrate manufacturing method according to a third aspect of the present invention includes steps of: forming a mask pattern on an Si substrate so as to expose a part of the surface of the Si substrate; forming an AlN buffer layer on the Si substrate on which the mask pattern is formed; and forming a group III nitride semiconductor layer on the AlN buffer layer.

According to the present invention, by covering the Si substrate with the mask pattern, diffusion of a group III element into the Si substrate can be suppressed. This can suppress a reduction in the resistivity of the surface of the Si substrate due to diffusion of the group III element into the Si substrate.

In the present invention, the ratio of the coverage area by the mask pattern to the exposed surface of the Si substrate is preferably 0.5 to 10. In this case, the mask pattern is, for example, a stripe pattern, and the line width of the stripe pattern is preferably 0.1 µm to 2 µm. Thus, it is possible to suppress diffusion of a group III element into the Si substrate while ensuring flatness of the surface of the group III nitride semiconductor layer.

In the present invention, the mask pattern is preferably made of a polycrystalline or amorphous material and is also preferably made of SiO₂ or SiNₓ. The thickness of the mask pattern is preferably 5 nm to 300 nm, and the thickness of the AlN buffer layer is preferably 10 nm to 300 nm. Thus, it is possible to suppress diffusion of a group III element into the Si substrate while ensuring the flatness of the surface of the group III nitride semiconductor layer.

In the present invention, the resistivity of the surface of the Si substrate is preferably 500 Ωcm or more. Thus, there can be provided a group III nitride semiconductor substrate with a high resistivity of the surface of the Si substrate and less current leak paths and parasitic capacitance, suitably used as a material for power semiconductors and high-frequency semiconductor devices.

Further, a group III nitride semiconductor substrate according to a fourth aspect of the present invention includes: an Si substrate; an AlN buffer layer formed on the Si substrate; and a group III nitride semiconductor layer formed on the AlN buffer layer. The resistivity of the surface of the Si substrate contacting the AlN buffer layer is 500 Ω or more. According to the present invention, there can be provided a group III nitride semiconductor substrate with a high resistivity of the surface of the Si substrate and less current leak paths and parasitic capacitance, suitably used as a material for power semiconductors and high-frequency semiconductor devices.

### [Effects of the Invention]

As described above, according to the present invention, there can be provided a group III nitride semiconductor substrate manufacturing method capable of suppressing a reduction in the resistivity of the surface of the Si substrate due to diffusion of a group III element into the Si substrate. Further, according to the present invention, there can be provided a group III nitride semiconductor substrate in which a group III nitride semiconductor layer is formed on the Si substrate with a high surface resistivity.

### BRIEF DESCRIPTION OF THE DRAWINGS

[FIG. 1] FIG. 1 is a schematic cross-sectional view illustrating a structure of a group III nitride semiconductor substrate manufactured by a group III nitride semiconductor substrate manufacturing method according to a first embodiment of the present invention.
[FIG. 2] FIG. 2 is a cross-sectional view schematically illustrating a configuration of an MOCVD apparatus used for the formation of a group III nitride semiconductor.
[FIG. 3] FIG. 3 is a flowchart for explaining the group III nitride semiconductor substrate manufacturing method according to the first embodiment.
[FIG. 4] FIG. 4 is a schematic cross-sectional view of the MOCVD apparatus for explaining a manufacturing process for the group III nitride semiconductor substrate according to the first embodiment.
[FIG. 5] FIG. 5 is a sequence diagram illustrating an example of feeding timings of NH₃ and TMA upon the formation of the first AlN layer.
[FIG. 6] FIG. 6 is a view for explaining a group III nitride semiconductor substrate manufacturing method according to a second embodiment of the present invention and is a sequence diagram illustrating an example of feeding timings of NH₃ and TMA upon the formation of the first AlN layer.
[FIG. 7] FIGS. 7A and 7B are views illustrating a structure of a group III nitride semiconductor substrate manufactured by a group III nitride semiconductor substrate manufacturing method according to a third embodiment of the present invention, wherein FIG. 7A is a schematic cross-sectional side view, and FIG. 7B is a cross-sectional plan view taken along line X-X in FIG. 7A.
[FIG. 8] FIG. 8 is a flowchart for explaining the group III nitride semiconductor substrate manufacturing method according to the third embodiment.
[FIG. 9] FIG. 9 is a table showing the evaluation results for the group III nitride semiconductor substrate according to Examples 1 to 5 and Comparative Example 1, and values of each item are relative values based on the results of Comparative Example 1.

### MODE FOR CARRYING OUT THE INVENTION

Hereinafter, preferred embodiments of the present invention will be described in detail with reference to the accompanying drawings.

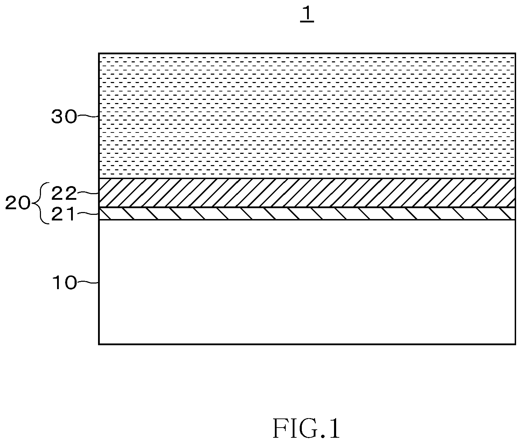

FIG. 1 is a schematic cross-sectional view illustrating a structure of a group III nitride semiconductor substrate manufactured by a group III nitride semiconductor substrate manufacturing method according to a first embodiment of the present invention.

As illustrated in FIG. 1, a group III nitride semiconductor substrate 1 has a structure in which an AlN buffer layer 20 and a group III nitride semiconductor layer 30 are laminated in this order on an Si substrate 10. The resistivity of the Si substrate 10 is 500 Ωcm or more and, preferably, 1000 Ωcm or more. Further, the plane orientation of the Si substrate 10 is preferably a (111) plane, but not limited thereto.

The AlN buffer layer 20 is a layer for reducing the lattice mismatch between the Si substrate 10 and the group III nitride semiconductor layer 30. The thickness of the AlN buffer layer 20 is preferably 30 nm to 200 nm. When the thickness of the AlN buffer layer 20 is smaller than 30 nm, the crystallinity of the AlN buffer layer 20 cannot be improved, and when the thickness thereof exceeds 200 nm, cracks are more likely to occur in the AlN buffer layer 20.

The AlN buffer layer 20 preferably has a double-layer structure in which a first AlN layer 21 and a second AlN layer 22 are laminated in this order. The first AlN layer 21 is a layer grown at a low temperature of 400°C to 1000°C, preferably, 400°C to 800°C, and the second AlN layer 22 is a layer grown at a high temperature of 900°C to 1200°C. The thickness of the first AlN layer 21 is preferably 0.4 nm to 100 nm, and more preferably, 0.4 nm to 50 nm. When the thickness of the first AlN layer 21 is smaller than 0.4 nm, diffusion of a group III element into the Si substrate 10 cannot be suppressed, and when the thickness thereof exceeds 100 nm, the crystallinity of AlN is deteriorated, which in turn deteriorates the crystallinity of the group III nitride semiconductor layer 30 formed thereon.

The group III nitride semiconductor layer 30 is a layer formed of a mixed crystal of at least one of Al, In, and Ga which are group III elements, and N, and a typical group III nitride semiconductor is GaN. The group III nitride semiconductor layer 30 may have a multilayer structure in which a GaInN layer and a GaN layer are sequentially laminated. The thickness of the group III nitride semiconductor layer 30 is not particularly limited and may be, e.g., 1 µm.

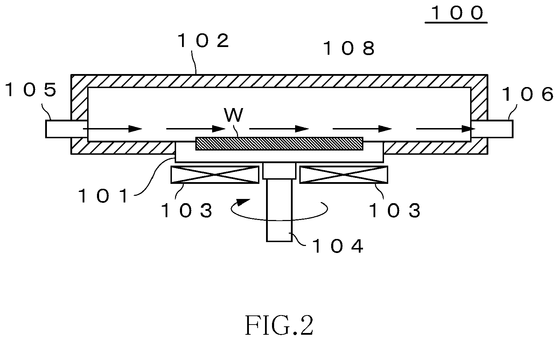

FIG. 2 is a cross-sectional view schematically illustrating a configuration of an MOCVD apparatus used for the formation of a group III nitride semiconductor.

As illustrated in FIG. 2, an MOCVD apparatus 100 is an apparatus for growing a group III nitride semiconductor by MOCVD (Metal organic Chemical Vapor Deposition) and includes a susceptor 101 for supporting a wafer W, a furnace 102 (chamber) housing the susceptor 101, a heater 103 disposed below the susceptor 101 and configured to heat the wafer W set on the susceptor 101, a rotary shaft 104 for rotating the wafer W together with the susceptor 101, a gas inlet 105 for feeding a carrier gas or a raw material gas into the furnace, and a gas outlet 106 for sucking and exhausting an atmospheric gas in the furnace. The gas outlet 106 is positioned on the side opposite to the gas inlet 105 with respect to the susceptor 101, and the gas inlet 105 blows gas against the wafer W in the lateral direction, whereby a gas flow path parallel to the wafer W is formed in the furnace as denoted by the arrows. The temperature of the heater, the rotating speed of the rotary shaft, the flow rate of the carrier gas or raw material gas to be fed into the furnace through the gas inlet 105, and the like are controlled by a not-shown control part.

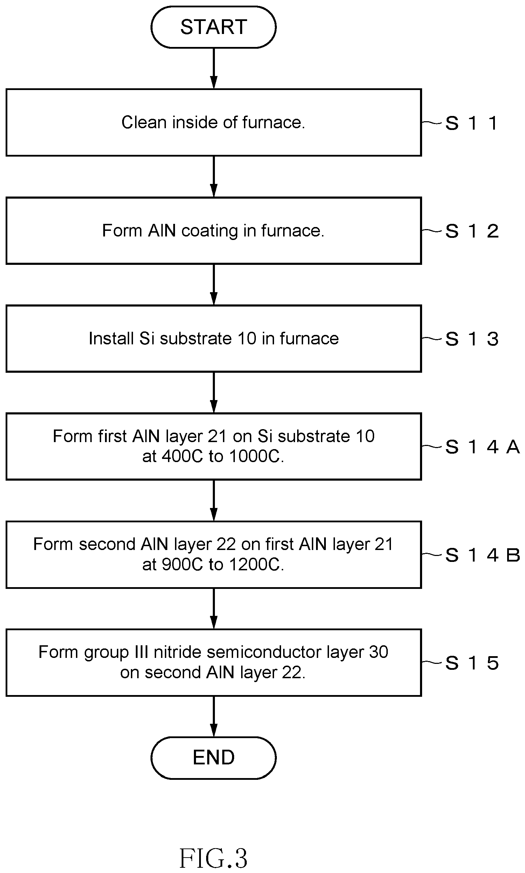

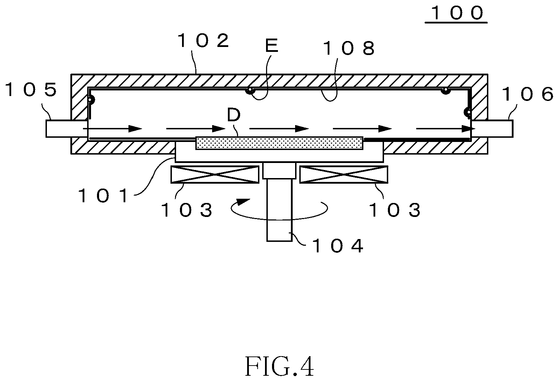

FIG. 3 is a flowchart for explaining the group III nitride semiconductor substrate manufacturing method according to the first embodiment. FIG. 4 is a schematic cross-sectional view of the MOCVD apparatus for explaining a manufacturing process for the group III nitride semiconductor substrate according to the first embodiment.

As illustrated in FIG. 3, in the manufacture of the group III nitride semiconductor substrate 1, the inside of the furnace 102 of the MOCVD apparatus 100 is cleaned (step S11). In the cleaning of the furnace 102, a purge gas containing H₂ is introduced into the furnace under high temperature atmosphere to remove residues in the furnace. In the furnace 102, a deposit containing a group III element such as Ga or In that has been introduced in the previous process. If the deposit is not removed, the amount of the deposit gradually increases. As a result, the deposit adheres to the Si substrate 10 as particles to cause pits to be formed in a semiconductor surface which grows subsequently to result in deterioration of device characteristics, or a decomposed group III element diffuses into the Si substrate 10. The group III element that has diffused into the Si substrate 10 becomes a p-type dopant to generate a carrier in the vicinity of the surface of the Si substrate 10 to reduce the resistivity of the surface of the Si substrate 10. Further, the carrier that has been generated in the vicinity of the surface of the Si substrate 10 causes a leak current to pass the Si substrate 10, which becomes a parasitic capacitance in a high-frequency device. However, by cleaning the inside of the furnace 102 to remove the deposit, diffusion of the group III element into the Si substrate 10 can be suppressed. Thus, it is possible to maintain the resistivity of the surface of the Si substrate 10 contacting the AlN buffer layer 20 at 500 Ωcm or more.

The in-furnace temperature during the cleaning of the furnace 102 is preferably 1000°C to 1400°C. When the in-furnace temperature is lower than 1000°C, the effect of decomposing a group III-V deposit is low, and when the in-furnace temperature is higher than 1400°C, high temperature durable components need to be employed to result in cost increase. The amount of time to remove the group III-V deposit may be adjusted for the amount of time taken for the previous film formation.

Then, as illustrated in FIG. 4, an AlN coating 108 is formed inside the furnace 102 (step S12). Although a group III-V deposit E remaining in the furnace 102 can be removed to some extent by baking the inside of the furnace 102 of the MOCVD apparatus 100 under an H₂-containing atmosphere as described above, it cannot be completely removed but slightly remains in the furnace 102. The group III-V deposit E containing Ga or In is easily decomposed at about 800°C, and Ga or In is released inside the furnace, while AlN is not decomposed until about 1200°C, so that Al is not released from the group III-V deposit E in the film formation process of the AlN coating 108. Thus, the group III-V deposit containing Ga or In is removed as much as possible by hydrogen baking of the inside of the furnace 102, and then the group III-V deposit E adhering to the inner surface of the furnace or in-furnace components is covered with the AlN coating 108, whereby diffusion of Ga or In into the Si substrate 10 can be suppressed.

In the formation process of the AlN coating 108, TMA (trimethylaluminum) as an Al raw material and NH₃ as an N raw material are introduced into the furnace 102 together with an H₂ carrier gas. The in-furnace temperature at this time is preferably 1000°C to 1400°C and, more preferably, 1100°C to 1200°C. When the in-furnace temperature is lower than 1000°C, good-quality AlN cannot be deposited in the furnace, and the AlN coating 108 is decomposed at a temperature at the time of forming the AlN buffer layer 20, so that Al diffuses into the Si substrate 10. On the other hand, when the in-furnace temperature is higher than 1400°C, high temperature durable in-furnace components need to be employed to result in cost increase.

The formation time of the AlN coating 108 is preferably 1 min to 30 min. When the formation time of AlN is less than 1 min, the effect of coating the group III-V deposit E is low, and when the formation time is more than 30 min, not only productivity is deteriorated, but also the adhering amount of AlN inside the furnace increases, causing particles during film formation.

In the formation process of the AlN coating 108, it is preferable to intermittently introduce NH₃ and more preferable to alternately introduce TMA and NH₃ plurality of times in a repeated manner. When TMA and NH₃ are introduced simultaneously, a variation in the thickness distribution of the AlN coating 108 becomes large due to high-speed reaction between TMA and NH₃. However, when TMA and NH₃ are introduced alternately, the inside of the furnace 102 can be coated uniformly with the AlN coating 108. TMA and NH₃ are each preferably fed for 0.5 sec to 10 sec. When the feeding time of TMA is less than 0.5 sec, Al does not sufficiently run through the inside of the furnace, with the result that a variation in the thickness distribution of the AlN coating becomes large. On the other hand, when the feeding time of TMA exceeds 10 sec, Al droplets are generated on the growth surface to cause particles. When the feeding time of NH₃ is less than 0.5 sec, Al droplets remain on the growth surface to cause particles. Although there is no particular problem even when the feeding time of NH₃ is increased, productivity will be deteriorated.

When TMA and NH₃ are alternately repeatedly introduced, the number of repetitions is preferably 5 to 200. When the number of repetitions is smaller than 5, sufficient AlN coating cannot be formed inside the furnace, resulting in decomposition of Ga or In. When the number of repetitions is larger than 100, the thickness of the AlN coating inside the furnace becomes excessively large. In this case, the AlN coating may easily peel off to cause particles.

It is preferable to install a dummy Si substrate D in the furnace 102 during the formation process of the AlN coating 108. In particular, when the furnace cleaning and AlN coating inside the furnace are continuously performed without lowering in-furnace temperature, the dummy Si substrate D is preferably installed in the furnace 102 before the start of the furnace cleaning. When the dummy Si substrate D is not installed in the furnace 102, the AlN coating 108 is inconveniently formed also on the susceptor 101 which is the installation area for the Si substrate 10 in the furnace 102. The presence of the AlN coating 108 on the susceptor 101 deteriorates heat conductivity of the susceptor 101, and a change in the temperature (film formation temperature) of the Si substrate 10 deteriorates reproducibility of the film formation process. However, when the dummy Si substrate D is installed in the furnace 102, it is possible to prevent the AlN coating 108 from being formed on the susceptor 101.

Then, the Si substrate 10 is prepared, washed with HF and SC-1, and then installed in the furnace 102 (step S13). The resistivity of the Si substrate 10 at this time is preferably 1000 Ωcm or more.

Then, the AlN buffer layer 20 is formed on the Si substrate 10 (steps S14A, S14B) . In the formation of the AlN buffer layer 20, TMA and NH₃ are introduced into the furnace at 400°C to 1200°C together with an Ar carrier gas to grow the first AlN layer 21 on the surface of the Si substrate 10 (step S14A). The growth temperature of the first AlN layer 21 is preferably 400°C to 1000°C and, more preferably, 400°C to 800°C. When the growth temperature is lower than 400°C, the crystallinity of AlN is deteriorated to affect the future crystallinity of a group III nitride semiconductor material, and when the growth temperature is higher than 1000°C, the effect of suppressing diffusion of the group III element into the Si substrate 10 is small. When the growth temperature of the first AlN layer 21 is 800°C or lower, the effect of suppressing diffusion of the group III element into the Si substrate 10 can be sufficiently enhanced.

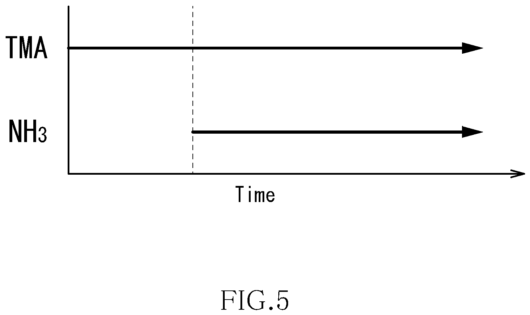

FIG. 5 is a sequence diagram illustrating an example of feeding timings of NH₃ and TMA upon the formation of the first AlN layer 21.

As illustrated in FIG. 5, it is preferable to feed TMA prior to NH₃ at the start of formation of the first AlN layer 21. In More detail, TMA is fed prior to NH₃ at the start of formation of the first AlN layer 21, and then TMA and NH₃ are fed together with NH₃ starting being fed after the elapse of a predetermined time from the start of feeding TMA. When NH₃ is fed prior to TMA, the surface of the Si substrate 10 reacts with NH₃ to be nitrided, failing to grow AlN having good crystallinity. In particular, when the Si substrate 10 has uneven in-plane temperature distribution, the surface of the Si substrate 10 is roughened to affect the future crystallinity of AlN. However, such a problem can be avoided when TMA is fed prior to NH₃.

When TMA is fed prior to NH₃, TMA is fed 3 sec to 30 sec prior to NH₃ so that Al atom in which TMA is decomposed is distributed to the entire surface of the Si substrate 10 in a thickness corresponding to one to ten atomic layers. When the Al atomic layer is thinner than one atomic layer, the Si substrate 10 reacts with NH₃ to be nitrided, deteriorating the crystallinity of AlN. On the other hand, when the Al atomic layer is thicker than ten atomic layers, Al droplets are generated on the surface of the Si substrate 10 to be alloyed with Si. As a result, deterioration in the crystallinity of AlN occurs on the Al-alloyed Si substrate.

Then, the second AlN layer 22 is formed on the first AlN layer 21 (step S14B) . In the formation of the second AlN layer 22, the in-furnace temperature is raised. Although the feeding of the raw material may be interrupted upon temperature rise, it is preferable to raise the temperature while feeding a raw material in consideration of productivity. The growth temperature of the second AlN layer 22 is preferably 900°C to 1200°C. When the growth temperature is lower than 900°C, the crystallinity of the AlN cannot be improved. Further an ordinary apparatus cannot support crystal growth at a high temperature exceeding 1200°C.

Then, the group III nitride semiconductor layer 30 is formed on the second AlN layer 22 (step S15). In the formation of the group III nitride semiconductor layer 30, the feeding of TMA is stopped and, instead, a group III raw material is fed together with NH₃ to grow the group III nitride semiconductor layer 30. The growth temperature of the group III nitride semiconductor layer 30 is preferably 900°C to 1200°C. When the growth temperature is lower than 900°C, the crystallinity of the group III nitride semiconductor layer cannot be improved. Thus, the group III nitride semiconductor substrate 1 in which the first AlN layer 21, the second AlN layer 22, and the group III nitride semiconductor layer 30 are laminated in this order is completed.

In the process of growing the group III nitride semiconductor layer 30 on the Si substrate 10 through the AlN buffer layer 20, when the AlN buffer layer 20 is grown at a high temperature of 900°C or higher from the initial stage of growth thereof for improving crystallinity, the Si substrate 10 may react with an Al raw material or Ga or In remaining in the furnace to cause the group III element to diffuse into the Si substrate 10 to disadvantageously reduce the resistivity of the surface of the Si substrate 10. However, when the first AlN layer 21 is grown thin at a low temperature of 400°C to 1000°C and then the second AlN layer 22 is grown at a high temperature of 900°C to 1200°C, reaction between the Si substrate and the group III element can be suppressed. As a result, the resistivity of the surface of the Si substrate 10 contacting the AlN buffer layer 20 can be maintained at 500 Ωcm or more.

At least a part of the series of processes from the formation of the AlN buffer layer 20 to the formation of the group III nitride semiconductor layer 30 is preferably carried out in the furnace 102 filled with an Ar gas. Thus, for example, before the start of formation of the AlN buffer layer 20, the in-furnace temperature may be raised after introduction of the Ar carrier gas in the furnace 102, and the group III nitride semiconductor layer 30 may be formed in the furnace 102 filled with the Ar gas. The Ar carrier gas makes it less likely to decompose the group III deposit in the furnace during growth than an H₂ carrier gas and does not nitride the surface of the Si substrate 10 unlike an N₂ gas. Thus, the crystallinity of the formed group III nitride semiconductor layer 30 is improved, and diffusion of the group III element into the Si substrate 10 can be suppressed.

As described above, in the manufacturing method for the group III nitride semiconductor substrate 1 according to the present embodiment, the inside of the furnace is baked before the start of a process of growing the group III nitride semiconductor on the Si substrate 10 to remove the group III deposit containing Ga or In remaining in the furnace to some extent, and then the AlN coating, which is less likely to be thermally decomposed, is formed on the inner surface of the furnace and the in-furnace components. As a result, contamination of the Si substrate by Ga or In can be suppressed.

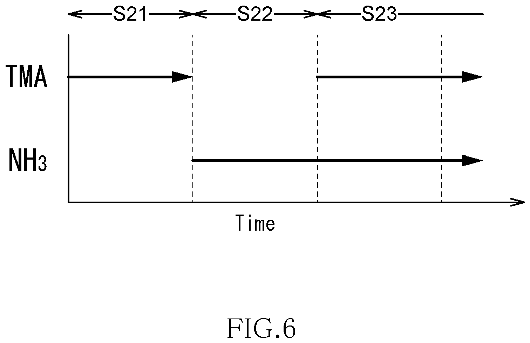

FIG. 6 is a view for explaining a group III nitride semiconductor substrate manufacturing method according to a second embodiment of the present invention and is a sequence diagram illustrating an example of feeding timings of NH₃ and TMA upon the formation of the first AlN layer.

As illustrated in FIG. 6, the manufacturing method for the group III nitride semiconductor substrate 1 according to the present embodiment is featured by including step S21 of feeding only TMA without feeding NH₃ at the start of formation of the AlN buffer layer 20 (first AlN layer 21), step S22 of temporarily stopping the feeding of TMA and starting the feeding of NH₃, and step S23 of resuming the feeding of TMA to feed both TMA and NH₃.

As illustrated in FIG. 5, when the feeding of NH₃ is started without interrupting the feeding of TMA, the feeding amount of TMA becomes excessive, causing Al to remain on the surface of the Si substrate 10. The remaining Al diffuses into the Si substrate 10 during the formation of the AlN buffer layer 20. However, when the feeding of TMA is stopped for a certain period of time from the start of feeding NH₃, Al remaining on the surface is nitrided, thus suppressing diffusion of Al into the Si substrate 10.

NH₃ is preferably fed for 1 sec to 180 sec and, more preferably, 3 sec to 60 sec. When the feeding time of NH₃ is less than 1 sec, Al is not sufficiently nitrided, and remaining Al diffuses into the Si substrate. Although there is no particular problem even when the time during which only NH₃ is fed is more than 180 sec, the productivity may be deteriorated. Thereafter, TMA is fed together with NH₃ to grow AlN to a predetermined thickness.

The temperature up to the time when both TMA and NH₃ are fed together is preferably 400°C to 1200°C and, more particularly, 400°C to 800°C. When the growth temperature is lower than 400°C, the crystallinity of the AlN cannot be improved, and when the growth temperature is higher than 1200°C, Al is more likely to diffuse into the Si substrate in the step of only feeding TMA.

As described above, by stopping the feeding of TMA for a certain period of time from the start of feeding NH₃, it is possible to suppress diffusion of Al into the Si substrate due to excessive feeding of the Al raw material.

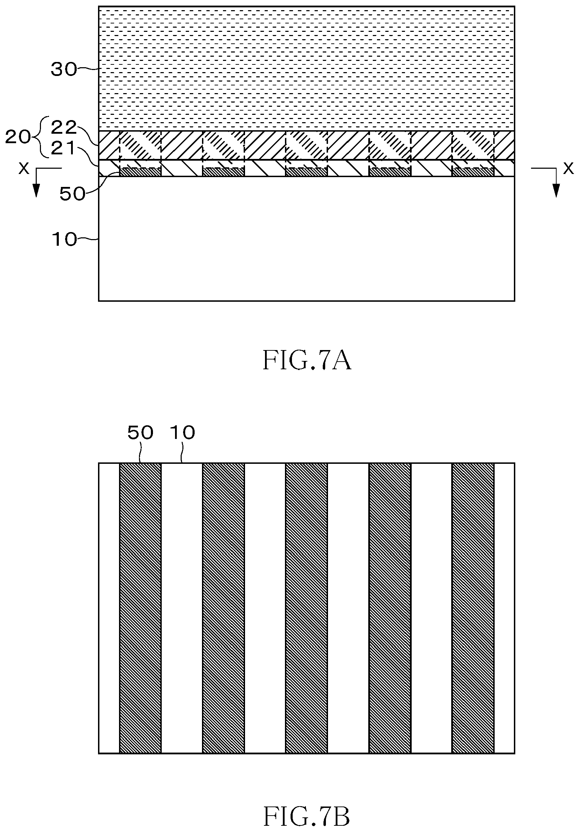

FIGS. 7A and 7B are views illustrating a structure of a group III nitride semiconductor substrate manufactured by a group III nitride semiconductor substrate manufacturing method according to a third embodiment of the present invention. FIG. 7A is a schematic cross-sectional side view and FIG. 7B is a cross-sectional plan view taken along line X-X in FIG. 7A.

As illustrated in FIGS. 7A and 7B, a group III nitride semiconductor substrate 2 is featured in that not only the AlN buffer layer 20 and group III nitride semiconductor layer 30 are laminated in this order on the Si substrate 10, but also a mask pattern 50 is formed between the Si substrate 10 and the AlN buffer layer 20. Other configurations are the same as those of the group III nitride semiconductor substrate 1 according to the first embodiment.

The mask pattern 50 is preferably made of a polycrystalline or amorphous SiO₂ or SiNₓ. Further, as illustrated in FIG. 7B, the mask pattern 50 according to the present embodiment is formed in stripes in a plan view. However, the mask pattern 50 is not particularly limited in shape as long as the surface of the Si substrate 10 is discretely exposed and may have a lattice shape or a hexagonal shape. When the mask pattern 50 is formed in stripes, the line width and space width are each preferably 0.1 µm to 2 µm.

The ratio of the coverage area by the mask pattern 50 to the exposed surface of the Si substrate 10 is preferably 0.5 to 10. When the coverage ratio is lower than 0.5, which means that the Si substrate is exposed in a large area, the effect of suppressing diffusion of the group III element into the Si substrate 10 is small. On the other hand, when the coverage ratio is higher than 10, which means that the Si substrate is exposed in a small area, GaN growing from the exposed part of the Si substrate 10 cannot sufficiently grow in the lateral direction, making it difficult to flatten the surface.

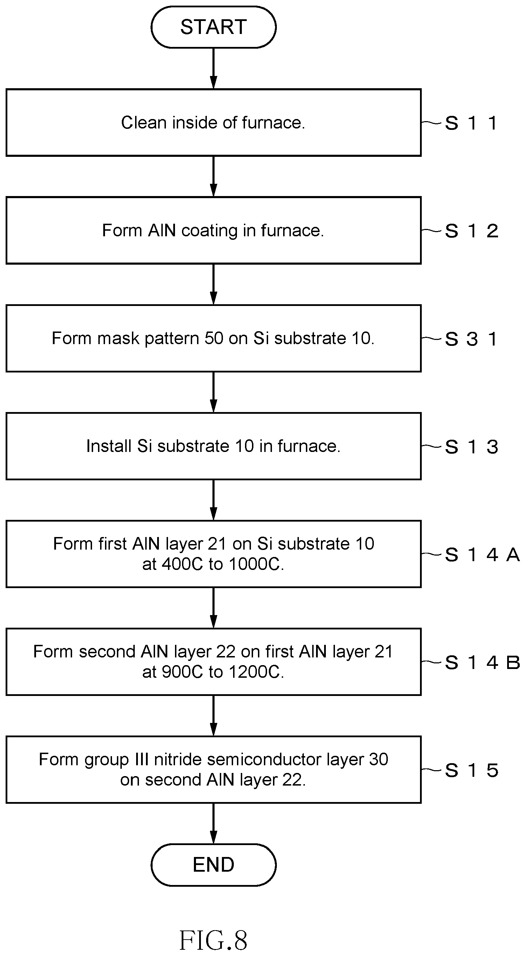

FIG. 8 is a flowchart for explaining the group III nitride semiconductor substrate manufacturing method according to the third embodiment.

As illustrated in FIG. 8, in the manufacture of the group III nitride semiconductor substrate 2, a process of cleaning the inside of the furnace of the MOCVD apparatus (step S11) and a process of forming the AlN coating inside the furnace (step S12) are sequentially carried out. However, in the present embodiment, the above processes are not essential and, for example, the AlN coating formation process can be omitted.

Then, the Si substrate 10 is prepared, and the mask pattern 50 is formed on the Si substrate 10 (step S31). In the formation of the mask pattern 50, an SiO₂ film is formed on the entire main surface of the Si substrate 10 by using a thermal diffusion furnace or the like, and then the formed SiO₂ film is patterned into stripes by photolithography or dry etching.

After that, the Si substrate 10 on which the mask pattern 50 has been formed is washed with SC-1 and installed in the MOCVD furnace (step S13), and the AlN buffer layer 20 and group III nitride semiconductor layer 30 are sequentially formed (steps S14A, S14B, and S15). Thus, the group III nitride semiconductor substrate 2 illustrated in FIGS. 7 (a) and 7 (b) is completed.

In the present embodiment, the thickness of the AlN buffer layer 20 is preferably 10 nm to 300 nm. When the thickness of the AlN is smaller than 10 nm, a large crystal nucleus grows on the mask pattern 50 when the group III nitride semiconductor layer 30 is grown on the AlN buffer layer 20, making it difficult to flatten the group III nitride semiconductor layer 30. When the thickness of the AlN is larger than 300 nm, cracks are more likely to occur on the surface of the group III nitride semiconductor layer 30.

As described above, in the manufacturing method for the group III nitride semiconductor substrate 2 according to the present embodiment, the AlN buffer layer 20 is formed after the Si substrate 10 is covered with the mask pattern 50, so that diffusion of the group III element into the Si substrate 10 can be suppressed. Thus, it is possible to suppress a reduction in the resistivity of the surface of the Si substrate 10 due to diffusion of the group III element and thereby to maintain the resistivity of the surface of the Si substrate 10 at 500 Ωcm or more.

While the preferred embodiments of the present invention have been described, the present invention is not limited to the above embodiments, and various modifications may be made within the scope of the present invention, and all such modifications are included in the present invention.

For example, the group III nitride semiconductor substrate manufacturing methods according to the above first to third embodiments can be combined appropriately. Thus, for example, the second embodiment in which, upon the formation of the AlN buffer layer 20, feeding of the Al raw material is temporarily stopped, while feeding of the N raw material is started and the third embodiment in which the AlN buffer layer 20 is formed on the Si substrate 10 through the mask pattern 50 may be combined together. Further, the coating of the inside of the furnace with the AlN coating, which is the feature of the first embodiment, may not necessarily be carried out in the second and third embodiments and may be omitted.

Further, in the group III nitride semiconductor substrate manufacturing methods according to the first to third embodiments, upon the formation of the AlN buffer layer 20, the first AlN layer 21 is formed at a low temperature before the second AlN layer 22 is formed at a high temperature; however, the second AlN layer 22 may be formed at a high temperature from the beginning. In this case, the formation of the first AlN layer 21 may be omitted.

Further, in the above embodiments, a specific configuration of the MOCVD apparatus is not particularly limited. Furthermore, a formation method of the group III nitride semiconductor is not limited to the MOCVD, but may be other method such as HVPE (Hydride Vapor Phase Epitaxy) or MBE (Molecular Beam Epitaxy) . Even with the HVPE and MBE, it is possible to similarly suppress diffusion of impurities into the Si substrate.

### [Example 1]

### <Example 1>

The dummy Si substrate D was installed in the MOCVD furnace, and the inside of the furnace was baked for 30 min under an H₂ atmosphere at 1200°C for cleaning. Then, at 1100°C, NH₃ was introduced for 5 min, and then TMA was introduced for 10 min to form the AlN coating inside the furnace. Thereafter, the in-furnace temperature was lowered, and the dummy Si substrate was taken out of the furnace.

Then, an Si substrate having a resistivity of 1000 Ωcm and a plane orientation of (111) was prepared, washed with HF and SC-1, and installed in the furnace. Then, after the in-furnace temperature was raised to 1000°C, TMA and NH₃ were introduced into the furnace together with an Ar carrier gas to grow the first AlN layer on the upper surface of the Si substrate to a thickness of 10 nm. Specifically, in the above process, TMA was fed first for 10 sec, and then NH₃ started being fed without stopping the feeding of TMA, whereby TMA and NH₃ were fed together. Thereafter, the in-furnace temperature was raised to 1100°C while TMA and NH₃ were continuously fed to grow the second AlN layer to a thickness of 90 nm.

Then, the feeding of TMA was stopped, and the in-furnace temperature was lowered to 1050°C while NH₃ was being continuously fed. Thereafter, TMG (trimethylgallium) as a Ga source was fed to grow a GaN layer on the upper surface of the second AlN layer to a thickness of 1 µm. In this manner, there was obtained a group III nitride semiconductor substrate of Example 1 in which the first AlN layer, second AlN layer, and GaN layer were laminated in this order on the Si substrate.

### <Example 2>

A group III nitride semiconductor substrate was produced under the same conditions as those in Example 1 except that TMA and NH₃ were alternately fed upon the formation of the AlN coating inside the furnace. Specifically, a process of introducing TMA into the furnace at 1200°C for 3 sec together with an Ar carrier gas and introducing NH₃ for 6 sec with an Ar carrier gas was repeated 50 times to form the AlN coating. Thereafter, the first AlN layer, second AlN layer, and GaN layer were formed in this order on the Si substrate, whereby a group III nitride semiconductor substrate of Example 2 was obtained.

### <Example 3>

A group III nitride semiconductor substrate was produced under the same conditions as those in Example 2 except the following point: upon growth of the AlN buffer layer, TMA was first introduced, then only NH₃ was introduced with introduction of TMA temporarily stopped and, thereafter, both TMA and NH₃ were fed. Specifically, TMA was first fed for 10 sec into the furnace whose temperature had been raised to 1000°C, then only NH₃ was fed for 20 sec with feeding of TMA temporarily stopped and, thereafter, feeding of TMA was resumed to feed TMA and NH₃ together. In this manner, there was obtained a group III nitride semiconductor substrate of Example 3.

### <Example 4>

A group III nitride semiconductor substrate was produced under the same conditions as those in Example 3 except the following point: upon the formation of the AlN buffer layer, the first AlN layer was grown at a low temperature of 600°C, and then the second AlN layer was grown at a high temperature of 1100°C. Specifically, TMA and NH₃ were introduced into the furnace at 600°C together with an Ar carrier gas to grow the first AlN layer on the upper surface of the Si substrate to a thickness of 10 nm. At this time, TMA was first introduced, then only NH₃ was introduced with the introduction of TMA temporarily stopped and, thereafter, both TMA and NH₃ were fed. After that, the in-furnace temperature was raised to 1100°C while both TMA and NH₃ were continuously fed to grow the second AlN layer on the upper surface of the first AlN layer to a thickness of 90 nm.

### <Example 5>

A group III nitride semiconductor substrate was produced under the same conditions as those in Example 2 except that the AlN buffer layer and the GaN layer were laminated in this order after the formation of a stripe-shaped mask pattern made of SiO₂ on the Si substrate. Specifically, SiO₂ polycrystalline film was formed to a thickness of 100 nm to cover the entire surface of the Si substrate and was then patterned in stripes having a line width of 1 µm and a space width of 1 µm to partially expose the surface of the Si substrate. Thereafter, the first AlN layer, the second AlN layer, and the GaN layer were formed in this order on the Si substrate on which the mask pattern had been formed, whereby a group III nitride semiconductor substrate of Example 5 was obtained.

### <Comparative Example 1>

A group III nitride semiconductor substrate of Comparative Example 1 was produced under the same conditions as those in Example 1 except that the AlN coating was not formed inside the furnace. Since the AlN coating was not formed inside the furnace, the dummy Si substrate was not used either.

The thus produced group III nitride semiconductor substrates according to Examples 1 to 5 and Comparative Example 1 were evaluated in terms of Ga, Al, and carrier concentrations on the surface of the Si substrate. The Ga and Al concentrations on the surface of the Si substrate were evaluated by SIMS (Secondary Ion Mass Spectrometry). The carrier concentration was evaluated as the sum of the Ga and Al concentrations.

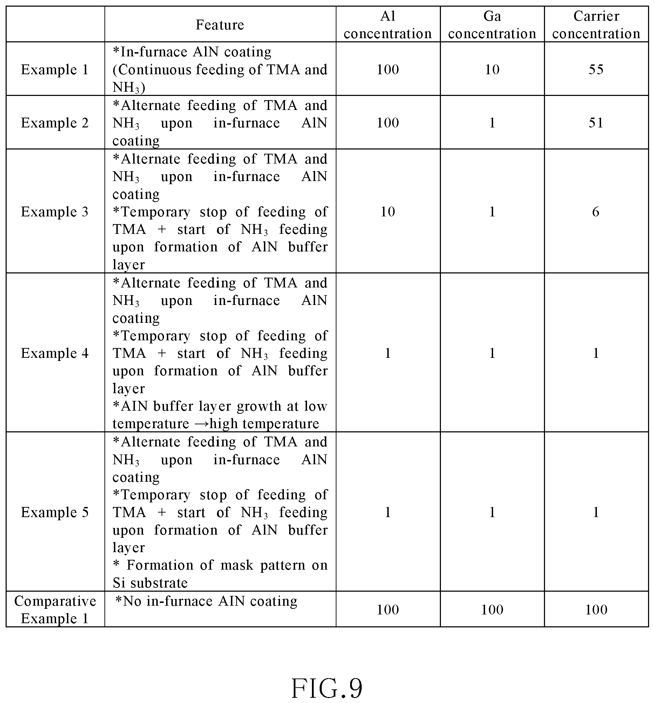

FIG. 9 is a table showing the evaluation results for the group III nitride semiconductor substrate according to Examples 1 to 5 and Comparative Example 1. Values of each item are relative values based on the results of Comparative Example 1.

As shown in FIG. 9, in the group III nitride semiconductor substrate of Example 1 produced in the furnace in which the AlN coating was formed, the Al concentration of the surface of the Si substrate was 100, the Ga concentration thereof was 10, and the carrier concentration thereof was 55. Further, in Example 2 in which the Al raw material and N raw material were alternately fed upon the formation of the AlN coating, the Al concentration thereof was 100, the Ga concentration thereof was 1, and the carrier concentration thereof was 51. Thus, the Ga concentration was more favorable in Example 2 than Example 1.

In Example 3 in which, upon the formation of the AlN buffer layer, only NH₃ was introduced with introduction of TMA temporarily stopped, the Al concentration thereof was 10, Ga concentration thereof was 1, and carrier concentration thereof was 6. Thus, the Al concentration was better in Example 3 than Example 2.

In Example 4 in which the first AlN layer was grown at a low temperature of 600°C, the Al concentration thereof was 1, the Ga concentration thereof was 1, and the carrier concentration thereof was 1. Thus, Example 4 exhibited more favorable results than those of Example 3. Further, in Example 5 in which the mask pattern was formed on the Si substrate, the Al concentration thereof was 1, the Ga concentration thereof was 1, and the carrier concentration thereof was 1. Thus, like Example 4, Example 5 exhibited more favorable results.

### [Description of Reference Numerals]

- 1, 2: Group III nitride semiconductor substrate
- 10: Si substrate
- 20: AlN buffer layer
- 21: First AlN layer
- 22: Second AlN layer
- 30: Group III nitride semiconductor layer
- 50: Mask pattern
- 100: MOCVD apparatus
- 101: Susceptor
- 102: Furnace (chamber)
- 103: Heater
- 104: Rotary shaft
- 105: Gas inlet
- 106: Gas outlet
- 108: AlN coating
- D: Dummy Si substrate
- E: Group III-V deposit
- W: Wafer

## Claims

1. A group III nitride semiconductor substrate manufacturing method comprising steps of:
forming an AlN coating inside a furnace;
installing an Si substrate in the furnace whose inside is covered with the AlN coating and forming an AlN buffer layer on the Si substrate; and
forming a group III nitride semiconductor layer on the AlN buffer layer.

2. The group III nitride semiconductor substrate manufacturing method according to Claim 1, wherein
the formation temperature of the AlN coating is 1000°C to 1400°C.

3. The group III nitride semiconductor substrate manufacturing method according to Claim 1 or 2, wherein formation time of the AlN coating is 1 min to 30 min.

4. The group III nitride semiconductor substrate manufacturing method according to any one of Claims 1 to 3, wherein the step of forming the AlN coating introduces an Al raw material and an N raw material alternately and repeatedly into the furnace.

5. The group III nitride semiconductor substrate manufacturing method according to Claim 4, wherein a per unit time for intruction of each of the Al raw material and the N raw material is 0.5 sec to 10 sec

6. The group III nitride semiconductor substrate manufacturing method according to Claim 4 or 5, wherein the number of repetitions is 5 to 200.

7. The group III nitride semiconductor substrate manufacturing method according to any one of Claims 1 to 6 further comprising a step of cleaning the inside of the furnace under a hydrogen-containing atmosphere before the formation of the AlN coating.

8. The group III nitride semiconductor substrate manufacturing method according to any one of Claims 1 to 7 further comprising steps of:
installing a dummy Si substrate in the furnace before the formation of the AlN coating; and
taking the dummy Si substrate out of the furnace before installing the Si substrate in the furnace.

9. The group III nitride semiconductor substrate manufacturing method according to any one of Claims 1to 8, wherein the group III nitride semiconductor layer contains a GaN layer.

10. The group III nitride semiconductor substrate manufacturing method according to any one of Claims 1 to 9, wherein the growth temperature of the AlN buffer layer is 400°C to 1200°C.

11. The group III nitride semiconductor substrate manufacturing method according to any one of Claims 1 to 10, wherein
the step of forming the AlN buffer layer includes steps of:
growing a first AlN layer at a growth temperature of 400°C to 800°C; and
growing a second AlN layer on the first AlN layer at a growth temperature of 900°C to 1200°C.

12. The group III nitride semiconductor substrate manufacturing method according to any one of Claims 1 to 11, wherein
the step of forming the AlN buffer layer includes, when an Al raw material and an N raw material are introduced into the furnace, introducing the Al raw material prior to the N raw material.

13. The group III nitride semiconductor substrate manufacturing method according to any one of Claims 1 to 12, wherein at least one of the step of raising the in-furnace temperature before the start of formation of the AlN buffer layer, the step of forming the AlN buffer layer, and the step of forming the group III nitride semiconductor layer uses an Ar gas as an atmospheric gas in the furnace.

14. The group III nitride semiconductor substrate manufacturing method according to any one of Claims 1 to 13, wherein
the step of forming the AlN buffer layer includes,
feeding an Al raw material without feeding an N material when the Al raw material and the N raw material are introduced into the furnace,
starting the feeding of the N raw material with the feeding of the N raw material temporarily stopped, and
resuming the feeding of the Al raw material to feed both the N raw material and the Al raw material.

15. The group III nitride semiconductor substrate manufacturing method according to Claim 14, wherein the feeding time of the N raw material during temporary stop of feeding of the Al raw material is 1 sec to 180 sec.

16. The group III nitride semiconductor substrate manufacturing method according to any one of Claims 1 to 15 further comprising a step of forming a mask pattern on the Si substrate so as to expose a part of the surface of the Si substrate before forming the AlN buffer layer, wherein
the AlN buffer layer is formed on the Si substrate on which the mask pattern is formed.

17. The group III nitride semiconductor substrate manufacturing method according to Claim 16, wherein the ratio of the coverage area by the mask pattern to the exposed surface of the Si substrate is 0.5 to 10.

18. The group III nitride semiconductor substrate manufacturing method according to Claim 16 or 17, wherein the mask pattern is a stripe pattern, and the line width of the stripe pattern is 0.1 µm to 2 µm.

19. The group III nitride semiconductor substrate manufacturing method according to any one of Claims 16 to 18, wherein the mask pattern is made of a polycrystalline or amorphous material.

20. The group III nitride semiconductor substrate manufacturing method according to any one of Claims 16 to 19, wherein the mask pattern is made of SiO₂ or SiNₓ.

21. The group III nitride semiconductor substrate manufacturing method according to any one of Claims 16 to 20, wherein the thickness of the mask pattern is 5 nm to 300 nm.

22. The semiconductor substrate manufacturing method according to any one of Claims 16 to 21, wherein the thickness of the AlN buffer layer is 10 nm to 300 nm.

23. A group III nitride semiconductor substrate manufacturing method comprising steps of:
forming an AlN buffer layer on a Si substrate; and
forming a group III nitride semiconductor layer on the AlN buffer layer, wherein
the step of forming the AlN buffer layer includes:
feeding an Al raw material without feeding an N material into a furnace in which the Si substrate is installed,
starting the feeding of the N raw material with the feeding of the Al raw material temporarily stopped, and
resuming the feeding of the Al raw material to feed both the N raw material and the Al raw material.

24. The group III nitride semiconductor substrate manufacturing method according to Claim 23, wherein the feeding time of the N raw material during temporary stop of feeding of the Al raw material is 1 sec to 180 sec.

25. The group III nitride semiconductor substrate manufacturing method according to Claim 24, wherein the feeding time of the N raw material during temporary stop of feeding of the Al raw material is 3 sec to 60 sec.

26. The group III nitride semiconductor substrate manufacturing method according to any one of Claims 23 to 25, wherein the growth temperature of the AlN buffer layer is 400°C to 1200°C.

27. The group III nitride semiconductor substrate manufacturing method according to any one of Claims 23 to 26, wherein the growth temperature of the AlN buffer layer is 400°C to 800°C.

28. A group III nitride semiconductor substrate manufacturing method according comprising steps of:
forming a mask pattern on an Si substrate so as to expose a part of the surface of the Si substrate;
forming an AlN buffer layer on the Si substrate on which the mask pattern is formed; and
forming a group III nitride semiconductor layer on the AlN buffer layer.

29. The group III nitride semiconductor substrate manufacturing method according to Claim 28, wherein the ratio of the coverage area by the mask pattern to the exposed surface of the Si substrate is 0.5 to 10.

30. The group III nitride semiconductor substrate manufacturing method according to Claim 28 or 29, wherein the mask pattern is a stripe pattern, and the line width of the stripe pattern is 0.1 µm to 2 µm.

31. The group III nitride semiconductor substrate manufacturing method according to any one of Claims 28 to 30, wherein the mask pattern is made of a polycrystalline or amorphous material.

32. The group III nitride semiconductor substrate manufacturing method according to any one of Claims 28 to 31, wherein the mask pattern is made of SiO₂ or SiNₓ.

33. The group III nitride semiconductor substrate manufacturing method according to any one of Claims 28 to 32, wherein the thickness of the mask pattern is 5 nm to 300 nm.

34. The group III nitride semiconductor substrate manufacturing method according to any one of Claims 28 to 33, wherein the thickness of the AlN buffer layer is 10 nm to 300 nm.

35. The group III nitride semiconductor substrate manufacturing method according to any one of Claims 28 to 34, wherein the resistivity of the surface of the Si substrate is 500 Ωcm or more.

36. A group III nitride semiconductor substrate comprising:
an Si substrate;
an AlN buffer layer formed on the Si substrate; and
a group III nitride semiconductor layer formed on the AlN buffer layer, wherein
the resistivity of the surface of the Si substrate in contact with the AlN buffer layer is 500 Ωcm or more.
